Europäisches Patentamt

European Patent Office

Office européen des brevets

(19)

(11) Veröffentlichungsnummer: **0 078 873**
**B1**

(12) **EUROPÄISCHE PATENTSCHRIFT**

(45) Veröffentlichungstag der Patentschrift:
24.09.86

(21) Anmeldenummer: 82102261.3

(22) Anmeldetag: 19.03.82

(51) Int. Cl.⁴: **H 05 K 3/00**

(54) Vorrichtung zum automatischen Übertragen von Trägerplatten für gedruckte elektrische Schaltungen, aus einer Beladezone an eine Druckeinrichtung.

(30) Priorität: 09.11.81  IT 2492381

(43) Veröffentlichungstag der Anmeldung:
18.05.83 Patentblatt 83/20

(45) Bekanntmachung des Hinweises auf die Patenterteilung:
24.09.86 Patentblatt 86/39

(84) Benannte Vertragsstaaten:
AT BE CH DE FR GB LI LU NL SE

(56) Entgegenhaltungen:
DE-A-1 133 738
GB-A-1 568 343
US-A-4 068 994

(73) Patentinhaber: **Curti, Ezio, Viale Regina Giovanna, 38, I-20100 Milano (IT)**

(72) Erfinder: **Curti, Ezio, Viale Regina Giovanna, 38, I-20100 Milano (IT)**

(74) Vertreter: **Mayer, Hans Benno, Via dell'Orso 7/A, I-20121 Milano (IT)**

EP 0 078 873 B1

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die vorstehende Erfindung betrifft eine Vorrichtung, mit der automatisch Traegerplatten fuer gedruckte elektrische Schaltungen aus einer Beschickungszone in eine Druckzone befoerdert werden koennen.

Es ist zu diesem Zweck bereits bekannt, einen verfahrbaren Wagen einzusetzen, der eine Auflageflaeche, mit Bezugsstiften aufweist, die die zu bedruckende Traegerplatte, die geeignete Bezugsbohrungen aufweist, aufnehmen, vgl zum Beispiel die GB-A-1568343. Bei der bekannten Ausfuehrungsform, wird nach Zufuehren einer Traegerplatte, die zu bedrucken ist, der Wagen aus der Beschickungszone in die Druckeinrichtung verfahren. In der Druckeinrichtung wird der Wagen unter grossem Aufwand an Einstellmitteln, Steuer- und Kontrolleinrichtungen, genau in seiner Lage festgelegt, um zu gewaehrleisten, dass sich die zu bedruckende Traegerplatte genau unter der Druckvorrichtung befindet, die meistens aus einer Siebdruckmaschine besteht.

Nach Durchfuehren des Druckvorganges, kehrt der Wagen erneut in seine Beschickungsstellung zurueck, in der die nunmehr bedruckte Traegerplatte unter Verwendung bekannter Hilfsmittel von den Bezugsstiften angehoben wird, um zu ermoeglichen, dass eine neue Traegerplatte aufgelegt wird, die im Anschluss, einem weiteren Druckvorgang zu unterziehen ist.

Die bekannte, mit einem verfahrbaren Wagen ausgeruestete Vorrichtung, hat den Nachteil, dass zum Verschieben des Wagens aus der Beschickungszone in die sich unterhalb einer Druckvorrichtung befindende Druckzone, aufgrund der erforderlichen Genauigkeit in der Festlegung der Stellung des Wagens, ein erheblicher, maschinenbaulicher und elektrischer Aufwand erforderlich ist. Bei Verschieben des gesamten Wagens zusammen mit der Beladeflaeche unter die Druckvorrichtung, ist fernen keine Schnellarbeitsweise mit grossem Wirkungsgrad moeglich, da es stets erfoderlich ist zum Auflegen einer neuen Traegerplatte, die Ausfuehrung des Druckvorganges abzuwarten, damit der verfahrbare Wagen in seine Auslangslage zurueckkehren kann, wobei die bedruckte Traegerplatte bereits von dem mit Bezugsstifen ausgeruesteten Ebene abgehoben und abgefoerdert sein muss.

Ein weiterer Nachteil des bekannten Foerderwagens, ist in seiner unzulaenglichen Genauigkeit hinsichtlich der Festlegung der Traegerplatte unter der Druckeinrichtung zu sehen. Diese Genauigkeit muesste jedoch im Bereich der 1/100 mm liegen. Ferner kann bei Verwendung des bekannten Foerderwagens, die Wiederholbarkeit der Festlegung des Wagens auf keinen Fall gewaehrleistet werden.

Aus der DE-A-1133738 ist eine Einrichtung fuer zu bedruckendes Stueckgut bekannt mit einer Auflageflaeche, die in eine Beschickungszone und in eine Druckzone aufgeteilt ist, und mit Mitteln, um eine hin- und hergehende Translationsbewegung durchzufuehren.

Aufgabe der vorstehenden Erfindung ist es, die dem Stand der Technik anhaftenden Nachteile zu vermeiden und eine Beschickungseinrichtung vorzuschlagen, die wesentlich einfacher in ihrem konstruktiven Aufbau ist, die eine wiederholbare und sehr genaue Anordnung und Festlegung der Traegerplatte - unter der Druckvorrichtung ermoeglicht, und ferner um die Moeglichkeit zu schaffen, einer Beschickungsstation unbedruckte Traegerplatten zuzufuehren und diese bereits vorzujustieren, waehrend in der Druckstation nur noch der Druckvorgang durchgefuehrt wird, um somit den Leistungsgrad der Maschine wesentlich zu steigern.

Diese Aufgabe wird erfindungsgemaess dadurch geloest, dass eine einzige, fest angeordnete durchgehende Auflageflaeche vorgesehen ist, die in eine Beschickungszone und in eine Druckzone unterteilt ist, dass ferner steuerbare Klemmeinrichtungen, zum Erfassen einer Traegerplatte vorgesehen sind, und dass diese Klemmeinrichtungen mit Mitteln zur Durchfuehrung einer hin- und hergehenden Translationsbewegung, entlang einer Fuehrungsbahn, die parallel zur Auflageflaeche angeordnet ist, sowie zur Durchfuehrung einer senkrecht zur Auflageflaeche gerichteten Hubbewegung, ausgeruestet sind.

Mit einer Vorrichtung, die diese erfindungsgemaessen Merkmale aufweist, wird es ermoeglicht, die zu bedruckenden Traegerplatten in der fest angeordneten Beschickungszone aufzulegen, und vorab auf den Bezugsstiften zu justieren, dass weiterhin, unter Verwendung der Klemmeinrichtungen, die aufgelegte Traegerplatte erfasst und von den Bezugsstiften abgehoben wird, um anschliessend in die Druckzone gefoerdert zu werden, in der die Traegerplatte auf weitere Bezugsstifte, die in der Druckzone angeordnet sind, aufgesetzt wird. Im Anschluss wird die Traegerplatte von den Klemmeinrichtungen freigegeben, diese tauchen unter den Maschinentisch weg, um in die Beschickungszone zurueckzufahren, wo in der Zwischenzeit bereits eine neue, zu bedruckende Traegerplatte aufgelegt, und vor allem vorjustiert wurde. Diese neu aufgelegte Traegerplatte wird im Anschluss durch die Klemmeinrichtungen erfasst, wieder von den Bezugsstiften abgehoben und in die Druckzone verfahren.

Weitere vorteilhafte Merkmale der Erfindung, koennen den Unteranspruechen, der nun folgenden Beschreibung, sowie den beigefuegten Zeichnungen entnommen werden. Die erfindungsgemaesse Einrichtung wird nun genauer anhand eines Ausfuehrungsbeispieles beschrieben und in den Zeichnungen dargestellt.

Fig. 1 zeigt schematisch in perspektivischer Ansicht den Maschinentisch, der in eine Beschickungszone und in eine Druckzone unterteilt ist.

Fig. 2 - 7 zeigen schematisch den Bewegungsablauf, den die Klemmeinrichtungen waehrend der Beschickung und dem Transport einer Traegerplatte durchfuehren.

Fig. 8 zeigt schematisch eine Einrichtung, mit den zugehoerigen Antriebs- und Steuermitteln.

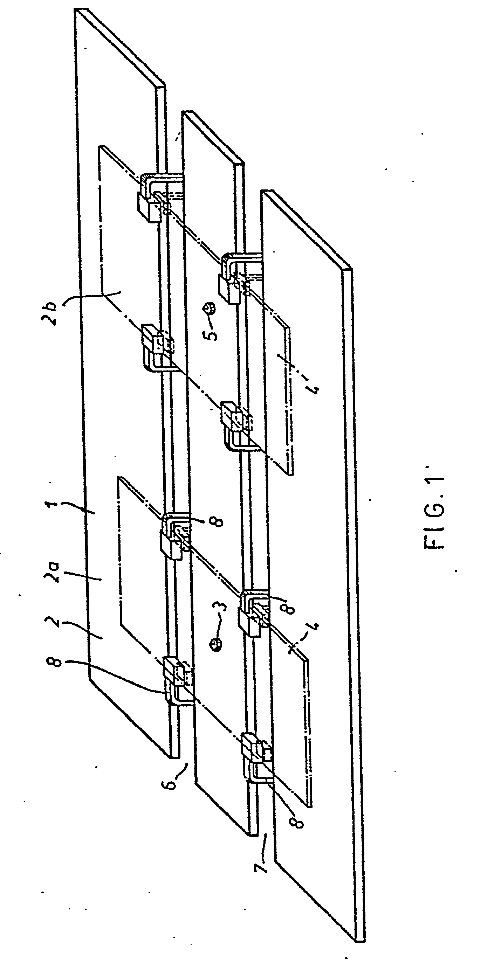

Wie der Fig. 1 zu entnehmen ist, weist die Druckmaschine 1 zum Bedrucken von Traegerplatten fuer elektrische Schaltkreise, eine einzige Auflageflaeche 2 auf, die in eine Beschickungszone 2a und in eine Druckzone 2b unterteilt ist. In der Beschickungszone 2a sind bekannte Bezugsstifte 3 vorgesehen, die ein Auflegen und vor allem ein Vorjustieren der zu bedruckenden Traegerplatte ermoeglichen.

Auch in der Druckzone 2b, sind entsprechende Bezugsstifte vorgesehen. Es ist bekannt, dass diese Bezugsstifte 3, 5 mit Bezugsbohrungen uebereinstimmen muessen, die in die Traegerplatte an geeigneter Stelle eingebracht sind. Aus diesem Grund, sind die Bezugsstifte 3, 5 einstellbar auszufuehren, z.B. durch Anordnen der Bezugsstifte in Langlochbohrungen oder aehnlichen Durchbruechen, die in die Auflageebene 2 eingebracht sind. Diese Mittel sind bei Siebdruckmaschinen der genannten Art allgemein ueblich. Es sei an dieser Stelle noch erwaehnt, dass der Achsabstand zwischen den entsprechenden Bezugsstiften (z.B. Dorn 3 und 5), stets konstant gehalten werden muss.

Die Auflageflaeche 2, weist in Laengsrichtung Einschnitte auf, die Oeffnungen oder Laengskanaele 6 und 7 bilden, in denen die Klemmeinrichtungen, die gesamthaft mit 8 gekennzeichnet sind, hin- und herlaufen koennen. Es hat sich als besonders vorteilhaft erwiesen, stets zwei Klemmeinrichtungen 8, zwei parallel zueinander verlaufenden Seiten einer Traegerplatte 4 zuzuordnen.

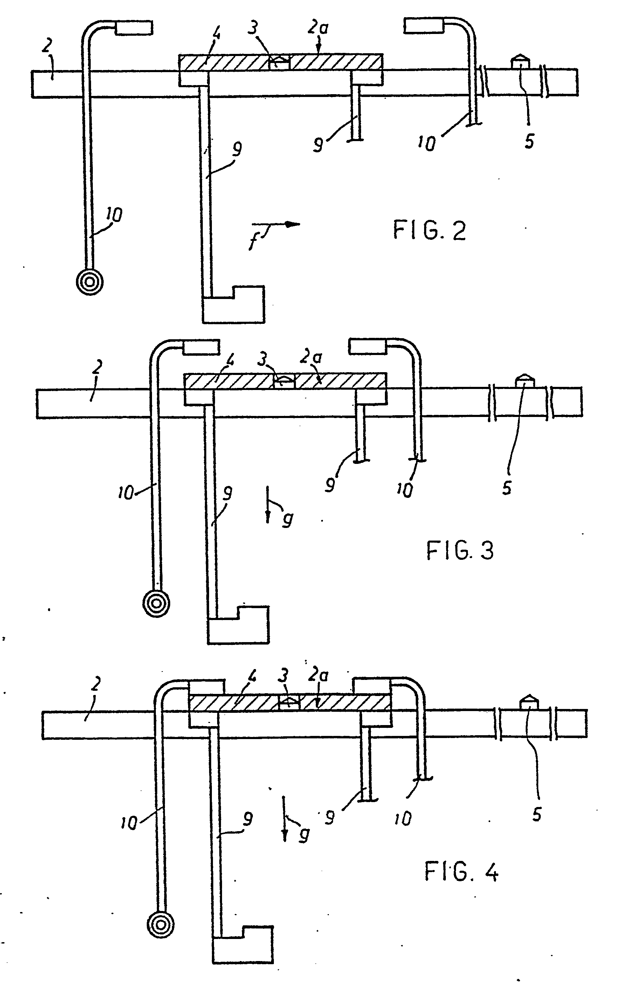

Aus der Fig. 1 kann dass Loesungsprinzip entnommen werden, d.h., die Vorsehung einer einzigen, fest angeordneten Auflageflaeche 2, mit einer Beschickungszone 2a, in der die zu bedruckende Traegerplatte 4 aufgelegt und vorjustiert wird, um anschliessend von Klemmeinrichtungen 8 abgehoben und in die Druckzone 2b uebertragen zu werden, in der nach erneutem festlegen und automatischem Justieren (Bezugsdorn 5) der Traegerplatte 4, diese im Siebdruckverfahren, unter Verwendung einer bekannten Siebdruckmaschine, die in geringem Abstand ueber der Maschinenebenen 2 angeordnet ist, bedruckt wird. Die einzelnen Verfahrensschritte werden genauer anhand der Fig. 2 - 7 erlaeutert.

In Fig. 2 ist schematisch eine Traegerplatte 4 dargestellt, die bereits auf dem Bezugsstift 3 der Beschickung sstation 2a angeordnet ist. Die Klemmeinrichtungen 8, bestehen aus einem fest angeordneten Auflager 9, das an der Unterseite der Traegerplatte 4 endet. Ferner, ist ein bewegliches Klemmelement 10 dargestellt, die im Anschluss noch genauer beschrieben wird.

Der Fig. 2 kann ferner entnommen werden, dass die Traegerplatte 4 bereits aufgelegt und auf dem Bezugsstift 3 der Beschickungsstation 2a vorjustiert wurde, waehrend der Bezugsstift 5 der Druckstation, noch frei ist und noch nicht durch eine zu bedruckende Traegerplatte besetzt wurde.

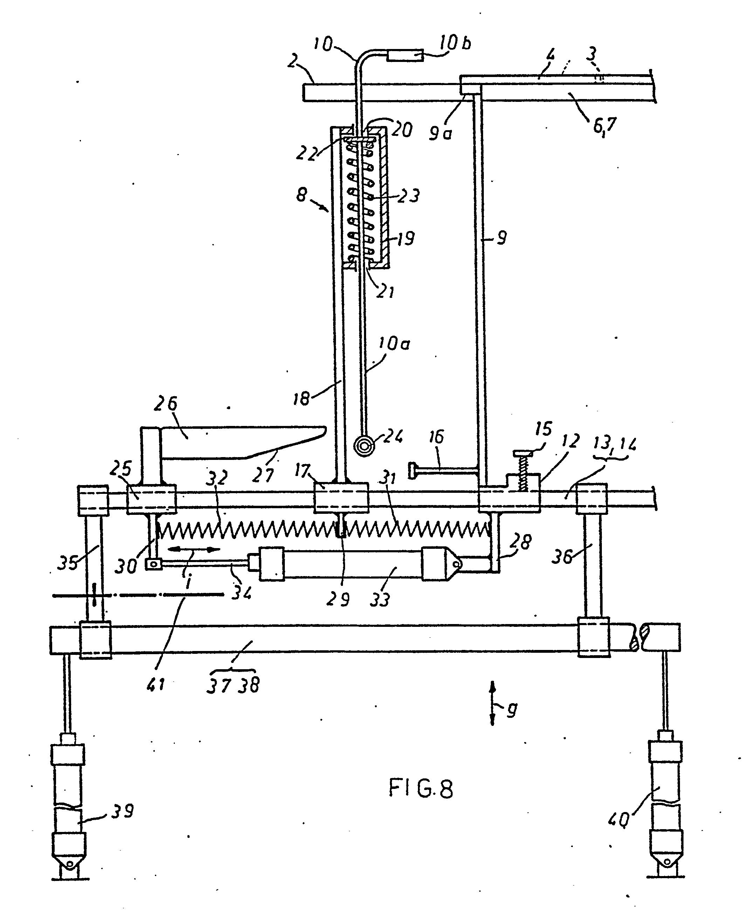

Unter Verwendung der Einrichtung, die noch genauer anhand der Fig. 8 beschrieben wird, werden die Klemmeinrichtungen 8 (zwei Einrichtungen fuer jede Traegerplattenseite 4) an die Kanten der Platte 4 herangefahren, wie dies in Fig. 3 dargestellt ist, d.h., das obere Ende des beweglichen Klemmelements 10 befindet sich ueber der Kante der Platte 4, in Uebereinstimmung mit dem entsprechenden Auflager 9.

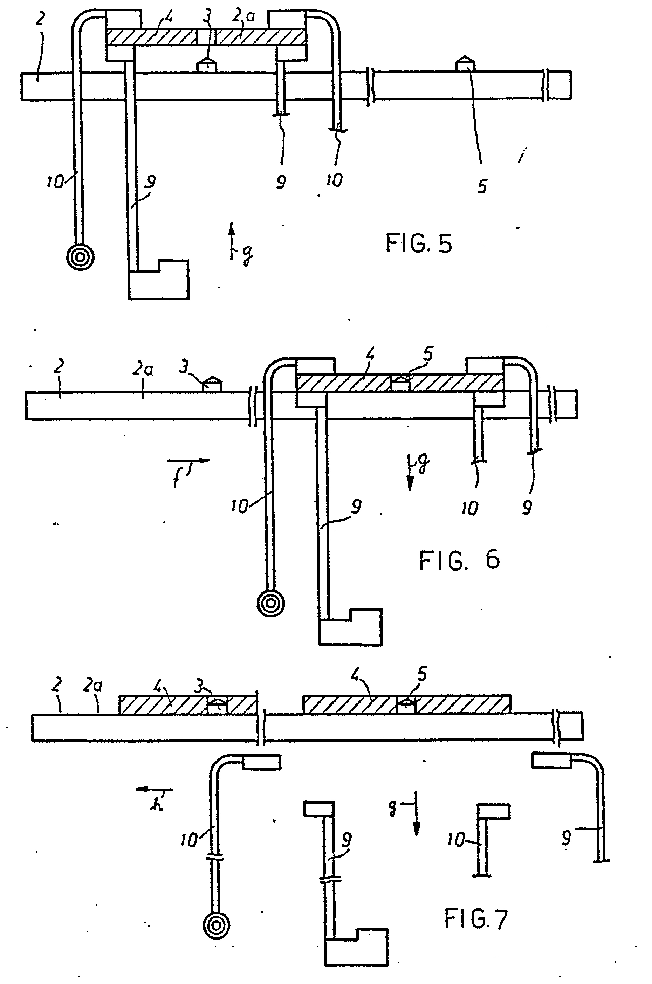

Der Fig. 4 kann entnommen werden, dass durch Absenken des beweglichen Klemmelements 10, ein Blockieren der Traegerplatte 4 zwischen das bewegliche Klemmelement 10 und den. unteren Auflagern 9 erfolgt. Werden nun alle Einrichtungen 8 durch die Oeffnungen 6 und 7 gemeinsam nach oben bewegt, so wird es ermoeglicht, die Traegerplatte 4 vom Bezugsstift 3 der Beschickungszone 2a, wie in Fig. 5 dargestellt, abzuheben. Werden nun gemeinsam saemtliche Einrichtungen 8 (in Richtung des Pfeiles f gemaess Fig. 5) auf den Bezugsstift 5 der Druckzone 2b zubewegt, und, werden im Anschluss alle Einrichtungen 8 in einer Stellung, in der die Bezugsbohrung 11 der Traegerplatte 4 mit dem Bezugsstift 5 uebereinstimmt, abgesenkt, so wird es ermoeglicht, die Traegerplette 4 mit groesster Genauigkeit (und genauer Lage), in der Druckstation 2b abzulegen. In der Zwischenzeit kann auf dem Bezugsstift 3 der Beschickungszone 2a, die nunmehr frei ist, bereits eine weitere Traegerplatte 4 aufgelegt und vorjustiert werden. Dies ist in der Fig. 7 dargestellt.

Nach Auflegen der Traegerplatte 4 in der Druckzone 2b, werden die Klemmeinrichtungen 8 derartig gesteuert, dass diese eine entgegengesetzte Bewegung zu den bisherigen Bewegungen gemaess Fig. 3 und 2 durchfuehren, wie dies in Fig. 7 dargestellt ist, d.h., die Klemmeinrichtungen bewegen sich stets in Richtung gemaess Pfeil g, um ueber die Laengsoeffnungen 6 und 7 unter die Maschinenebene 2 wegzutauchen, und somit die Rueckbewegung gemaess Pfeil h (Fig. 7), in Richtung der Beschickungszone 2a, durchzufuehren. Im Anschluss daran, wiederholen sich die bisher beschriebenen: Bewegungsablaeufe, die mit dem Erfassen und Anheben einer aufgelegten Traegerplatte gemaess Fig. 2 beginnen.

Der Antrieb und die Steuerung der bisher beschriebenen Klemmeinrichtungen, wird durch die in Fig. 8 schematisch dargestellten Bauteile ermoeglicht. Es sei darauf hingewiesen, dass diese Bauteile stets fuer jede Klemmeinrichtung 8 vorgesehen sind, nur aus Gruenden der Uebersichtlichkeit, wurde in Fig. 8 nur eine einzige dieser Einrichtungen dargestellt. Wie jedoch der Fig. 1 zu entnehmen ist, sind jeder parallelen Seite einer Traegerplatte 4 zwei dieser Einrichtungen 3 zugeordnet. Die Klemm-Einrichtungen sind auf geeigneten, parallel angeordneten Schienen oder Fuehrungen beweglich angeordnet.

Wie der Fig. 8 zu entnehmen ist, besteht jede Einrichtung 8 aus einer saeulenartigen Stuetze 9, deren oberes Ende 9a mit der Ebene 2 fluchtet und in den Laengsoeffnungen 6, bzw. 7 angeordnet ist, um eine Auflage fuer die Platte 4 darzustellen. An der Unterseite ist die Stuetze 9 mit einer Rohrhuelse 12 fest verbunden, die verschiebbar auf Fuehrungen 13 bzw. 14, die parallel zueinander angeordnet sind, vorgesehen ist. Um die Einrichtung 8, hauptsaechlich die Stuetze 9 gegenueber den Raendern der Traegerplatte 4 einstellen zu koennen, weist die verschiebbare Rohrhuelse 12 eine Einstell- und Blockierschraube 15 auf. Auf der dem beweglichen Klemmelement 10 zugekehrten Seite, weist die Stuetze 9 einen Anschlagarm 16 auf.

Die Fuehrungsschienen 13 und 14 tragen ferner, unter Verwendung weitere verschiebbarer Huelsen 17, eine senkrechte Saeule 18, an derem oberen Ende ein kleines Gehaeuse 19 angeordnet ist, das an seiner Oberseite und an seiner Unterseite mit einer Fuehrungsbohrung 20 bzw. 21 versehen ist. In diesen Bohrungen, ist eine stangenfoermige Verlaengerung 10a des Klemmelements 10 verschiebbar gefuehrt und in der Naehe der oberen Fuehrungsbohrung 20 ist das stangenfoermige Bauteil 10a fest mit einem Anschlag 22 verbunden, an dem eine Druckfeder 23 anliegt, dessen unteres Federende auf dem Grund des Gehaeuses 19, in der Naehe der unteren Fuehrungsbohrung 21, aufliegt. Das stangenfoermige Bauteil 10a, weist an seiner Unterseite eine Fuehrungsrolle 24 auf. An der Oberseite traegt das Klemmelement 10 eine Verdickung 10b, die zum Blockieren der Traegerplatte 4 geeignet ist.

Der Fig. 3 kann ferner entnommen werden, dass die Fuehrungsschienen 13, 14 eine weitere Schiebhuelse 25 tragen, von der ein waagerecht angeordneter Arm 26 absteht, der zur Fuehrungsrolle 24 hin gerichtet ist, und an seiner Unterseite eine schiefe Ebene 27 aufweist. Sowohl von der Schiebehuelse 12, als auch von der Huelse 17 und der Huelse 25, stehen an der Unterseite kleine Arme 28, 29 und 30 ab und zwischen dem Arm 28 und dem Arm 29, ist eine Druckfeder 31 vorgesehen und zwischen dem Arm 29 und dem Arm 30, ist eine Druckfeder 32 vorgesehen. In vorteilhafter Weise, ist die Kennlinie der Feder 31 derartig gewaehlt, dass die Federkraft dieser Feder 31 kleiner als die Federkraft der Feder 32 ist. Zwischen dem Arm 28 und dem Arm 30, ist ferner ein pneumatischer oder hydraulischer Arbeitskolben 33 vorgesehen. Das Ende der Kolbeneinheit 33 ist am Arm 28 befestigt, wogegen die Kolbenstange 34 mit dem Arm 30 in Wirkverbindung steht.

Die Fuehrungsschienen 13 und 14, werden von einem Rahmen, der schematisch durch die senkrechten Seitenteile 35 und 36 dargestellt ist, getragen. Der Rahmen 35, 36 ist verschiebbar auf parallel angeordneten Fuehrungsschienen 37 und 38 gelagert, die sich annaehernd ueber die gesamte Laenge der Maschinenflaeche 1 erstrecken. Die Enden der Fuehrungsschienen 37 und 38, sind z.B. ueber Antriebshebel betaetigbar oder, wie dies in vereinfachter Weise in Fig. 8 dargestellt ist, mit Arbeitskolben 39, 40 wirkverbunden, die die gesamte Baueinheit 8 in Richtung des Pfeiles g anheben oder absenken koennen.

Der Rahmen 35, 36 ist ferner mit einer Kette 41 oder einem aehnlichen Antriebsmitteln wirkverbunden und mit dieser Kette kann der Rahmen 35, 36 auf den Fuehrungsschienen 37, 38 hin- und herbewegte werden. Die der Kette 41 zugeordnete Antriebseinrichtung muss lediglich mit hoher Genauigkeit betaetigbar sein, um die zangenfoermige Einrichtung 8 stets mit Praezision in die gewuenschte Lage zu verschieben. Selbstverstaendlich, koennen anstelle des Kettenantriebs 41, denen ein steuerbarer Motor zugeordnet ist, auch andere, technisch aequivalente Antriebsmittel Verwendung finden. Es sei ausdruecklich darauf hingewiesen, dass anhand der Fig. 8 lediglich eine zangenfoermige Einrichtung 8 beschrieben wurde, dass aber auch auf der gegenueberliegenden Seite der Traegerplatte 4 analoge, Klemmeinrichtungen 8 angeordnet sind.

Jede Klemmeinrichtung 8 arbeitet wie folgt:
Nach Einstellen der Stuetze 9, unter Verwendung der Einstell- und Blockierschraube 15 und somit, nach Einstellen der gesamten Baueinheit 8 gegenueber der Traegerplatte 4, um somit das bewegliche Klemmelement 10 an die entsprechende Kante der Traegerplatte 4 anzunaehern, erfolgt ein Betaetigen der Kolbeneinheit 33, die ein Verschieben der Kolbenstange in Richtung der Pfeiles (i) vornimmt. Beruecksichtigt man, dass die Feder 31 in ihrer Kennlinie schwaecher als die Feder 32 ausgelegt ist, so tritt zuerst ein Verschieben des beweglichen Klemmelements 10, in Richtung der Traegerpaltte 4 ein, bis diese Verschiebebewegung durch den Anschlagarm 16 unterbunden wird. Da der Arbeitskolben 33 weiterhin durch das unter Druck stehende Medium beeinflusst wird, verschiebt sich im Anschluss der vorstehende Arm 26 mit der schiefen Ebene 27 in Richtung der Fuehrungsrolle 24, wodurch das gesamte bewegliche Klemmelement 10, 10a, 10b, des sich ueber der Traegerplatte 4 befindet, gegen die Wirkung der Feder 23 nach unten bewegt wird, wodurch die Traegerplatte 4 an den parallelen Kanten blockiert wird.

Im Anschluss werden die Arbeitskolben 39 und 40 betaetigt, wodurch alle Klemmeinrichtungen 8 nach oben bewegt werden und somit die Traegerplatte 4 von dem Bezugsstift 3 der Beschickungsstation 2a abheben.

Anschliessend, durch Betaetigen des Kettenantriebes 41, werden alle Einrichtungen 8, die die Traegerplatte 4 festhalten, von der Beschickungsstation 2a in die Druckstation 2b verschoben und duch ein entgegengesetztes Betaetigen der Kolben 3, 40, saemtliche Einrichtungen 8 nach unten abgesenkt werden und somit die Traegerplatte 4 genau auf der oder den Bezugsstiften 5 der Druckstation 2b absetzen.

Nach dem genauen justierten Absetzen der Traegerplatte 4 in der Druckstation 2, wird der Druck aus der Kolbeneinheit 33 abgeleitet, wodurch ueber die Feder 32 zuerst ein Verschieben des Armes 26 in seine urspruengliche Lage erfolgt, und somit die Fuehrungsrolle 24 freigegeben wird und ueber die Feder 23 das bewegliche Klemmelement 10, 10a, 10b nach oben verschoben wird, und eine Freigabe der Traegerplatte 4 erfolgt. Sofort im Anschluss daran, verschiebt die Feder 31 auch die Fuehrungshuelse 17 mit der Tragstuetze 18, zusammen mit dem beweglichen Klemmelement 10 in die entsprechende Ausgangslage, wodurch die Traegerplatte 4 vollkommen freigelegt wird.

Im Anschluss werden erneut die Arbeitskolben 39, 40 in entgegengesetzter Richtung betaetigt, wodurch saemtliche Einrichtungen 8 unter die Ebene 2 wegtauchen, und durch entsprechendes Betaetigen der Kette 41 werden saemtliche Einrichtungen 8 in ihre Ausgangslage zurueckbewegt, d.h., zur Beschickungsstation 2a zurueckgeschoben, in der zwischenzeitlich eine neue zu bedruckende Traegerplatte 4 aufgelegt und vorjustiert wurde.

Durch erneutes Betaetigen der Arbeitkolben 39 40 werden die Stuetzen 9 erneut in Uebereinstimmung mit der Ebene 2 gebracht, und die vorher beschriebenen und schematisch in den Fig. 2 - 7 dargestellten Vorgaenge zum Festspannen, Abheben und erneutem Verschieben und Ablegen der Traegerplatte 4, wiederholen sich. Die erfindungsgemaesse Vorrichtung hat den Vorteil, dass dank ihres einfachen Aufbaues, ein schnelles und einfaches Anpassen an die zu beschickenden und zu bedruckenden Traegerplatten mit unterschiedlichen Abmessungen, moeglich ist. Ferner kann eine Baueinheit verwendet werden, die vollstaendig unter dem Arbeitstisch der Maschine angeordnet ist, und die Arbeitskapazitaet der Druckeinrichtung weit besser ausgenuetzt werden kann.

**Patentansprueche**

1. Vorrichtung, zum automatischen Uebertragen von Traegerplatten fuer gedruckte elektrische Schaltungen aus einer Beschickungszone in eine Druckzone, dadurch gekennzeichnet, dass eine einzige, fest angeordnete, durchgehende Auflageflaeche (2) vorgesehen ist, die in eine Beschickungszone (2a) und in eine Druckzone (2b) aufgeteilt ist, dass steuerbare, Klemmeinrichtungen (8), zum Erfassen einer Traegerplatte (4) vorgesehen sind, und dass diese Klemmeinrichtungen (8) mit Mitteln (9 - 40) zur Durchfuehrung einer hin- und hergehenden Translationsbewegung, entlang einer parallel zur Auflageebene (2) der Vorrichtung angeordneten Fuehrungsbahn, sowie zur Durchfuehrung einer senkrecht zur Auflageflaeche ausgerichtete Hubbewegung, ausgeruestet sind.

2. Vorrichtung, nach Patentanspruch 1, dadurch gekennzeichnet, dass sowohl in der Beschickungszone (2a) als auch in der Druckzone (2b) Bezugsstifte (3) zum. Vorjustieren der Traegerplatte (4) bzw. Bezugsstifte (5) zum endgueltigen justieren der Traegerplatte (4), ueber Bezugsbohrungen in der Traegerplatte (4), vorgesehen sind.

3. Vorrichtung, nach Patentanspruch 1, dadurch gekennzeichnet, dass die Beschickungs- (2a) und Druckzone (2b) bildende Ebene (2) in der Richtung der Translationsbewegung, also in Laengsrichtung durch wenigstens zwei parallel zueinander angeordnete Laengsschlitze (6, 7) unterteilt ist, und dass die durch die Laengsschlitze hindurchtretenden Klemmeinrichtungen (9), frei in diesen Schlitzen (6, 7) hin- und herbewegbar und auf- und abbewegbar sind.

4. Vorrichtung, nach Patentanspruch 3, dadurch gekennzeichnet, dass durch jeden Laengschlitz (6, 7) wenigstens zwei Klemmeinrichtungan (8) nach oben ragen, von denen das erste der ersten Kante der Traegerplatte (4) und das zweite der zweiten, parallel angeordneten Kante der Traegerplatte (4) zugeordnet sind.

5. Vorrichtung, nach Patentanspruch 3, dadurch gekennzeichnet, dass jede Klemmeinrichtung (8) eine saeulenartige Stuetze (9, 9a) besitzt, die an ihrer Unterseite eine Gleithuelse (12) aufweist, dass auch das bewegliche Klemmelement (10) der Klemmeinrichtung (9) von einer saeulenfoermigen Stuetze (18) aufgenommen ist, die an ihrer Unterseite ebenfalls eine Gleithuelse (17) besitzt, und dass ferner ein abstehender Arm (26), mit einer schiefen Ebene (27) vorgesehn ist, der ebenfalls an seiner Unterseite eine Gleithuelse (25) aufweist, und, dass diese Gleithuelsen (12, 17, 25) verschiebbar, von parallel zueinander angeordneten und parallel zur Arbeitsebene (2) der Vorrichtung (1) angeordenten Fuehrungsschienen (13, 14) aufgenommen werden.

6. Vorrichtung, nach Patentanspruch 5, dadurch gekennzeichnet, dass der Schiebehuelse (12) der saeulenfoermigen Stuetze (9), eine Einstell- und Blockierschraube (15) zugeordnet ist.

7. Vorrichtung, nach Patentanspruch 5, dadurch gekennzeichnet, dass die saeulenfoermige Stuetze (9) ein Anschlagmittel (16) aufweist.

8. Vorrichtung, nach Patentanspruch 5, dadurch gekennzeichnet, dass das bewegliche Klemmelement (10) in einem Gehaeuse (19) gelagert ist, welches an seiner Oberseite und an seiner Unterseite Fuehrungsoeffnungen (20, 21) aufweist, und in seinem Inneren ein Federmittel (23) aufnimmt, das bestrebt ist, das bewegliche Klemmelement (10) nach oben zu verschieben.

9. Vorrichtung, nach Patentanspruch 5, dadurch gekennzeichnet, dass am unteren Ende (10a) des beweglichen Klemmelement (10) eine Steuerrolle (24) vorgesehen ist, die mit der schiefen Ebene (27) des waagerecht angeordneten Armes (26) wirkverbindbar ist.

10. Vorrichtung, nach Patentanspruch 5, dadurch gekennzeichnet, dass von den Gleithuelsen (12, 17, 25) der Stuetzsaeule (9), der Tragesaeule (18) des Klemmelements (10, 10a, 10b), sowie des waagerecht angeordneten Armes (26) mit der schiefen Ebene (27), Stuetzarme oder Rippen (28, 29, 30) abstehen, die zwischen der Huelse (12) der Stuetzsaeule (9) und der Tragesaeule (18) fuer das bewegliche Klemmelement (10, 10a, 10b), ein erstes Federmittel (31) und, zwischen der Gleithuelse (17) der Stuetzsaeule (18) und der Gleithuelse (25) des waagerecht angeordneten Armes (31), ein zweites Federmittel (32) aufnehmen, und dass das Federmittel (31) zwischen der Gleithuelse (12) der Stuetzsaeule (9) und der Haltesaeule (18) des beweglichen Klemmelements (10, 10a, 10b), eine geringere Federkraft aufweist, als die zwischen der Tragesaeule (18) des beweglichen (10) und der Gleithuelse (25) des waagerecht abstehenden Armes (26) angeordneten Feder (32).

11. Vorrichtung, nach Patentanspruch 10, dadurch gekennzeichnet, dass zwischen dem abstehenden Arm (28) der Gleithuelse (12) der Stuetzsaeule (9) und dem abstehenden Arm (30) der Gleithuelse (25) des horizontal angeordneten, die schiefene Ebene aufweisenden Armes (26), eine Kolbenzylindereinheit (33, 34) angeordnet ist.

12. Vorrichtung, nach Patentanspruch 5, dadurch gekennzeichnet, dass die parallel angeordneten Fuehrungsschienen, die die Gleithuelsen (12, 17, 25) aufnehmen, in einem Rahmengestell (35) angeordnet sind, das seinerseits verschiebbar von weiteren parallel angeordneten Fuehrungsschienen (37, 38), die parallel zu den Fuehrungsschienen (13, 14) der Gleithuelsen (12, 17, 25) angeordnet sind, aufgenommen wird.

13. Vorrichtung, nach Patentanspruch 12, dadurch gekennzeichnet, dass die den verschiebbaren Rahmen (35) aufnehmenden Fuehrungsschienen (37, 38), mit Hebelgestaengen oder Kolbenzylindereinheiten (39, 40) zum Anheben und Absenken dieser Fuehrungsschienen (37, 38), wirkverbunden sind.

14. Vorrichtung, nach Patentanspruch 12, dadurch gekennzeichnet, dass der verschiebbare Rahmen (35) mit einem von einer Kette (41), einem Seil oder einer Zahnstange gebildeten Antriebsmittel, in Wirkverbindung steht.

**Claims**

1. An apparatus for the automatic transfer of printed circuit boards or panels from a supply zone to a printing zone, characterised in that a single stationary continuous support surface (2) is provided and is divided into a supply zone (2a) and a printing zone (2b), controllable clamping means (8) for engaging a board (4) are provided, and the clamping means (8) have means (9 - 40) for performing a reciprocating displacement along a guide path parallel to the support surface (2) of the apparatus and to perform a lifting movement perpendicularly to the support surface.

2. An apparatus according to claim 1, characterised in that reference pins (3) for preadjusting the panel (4) are provided in the supply zone (2a) and reference pins (5) for final adjustment of the panel (4) are provided in the printing zone (2b), the pins (3, 5) co-operating with reference bores in the panel (4).

3. An apparatus according to claim 1, characterised in that the support surface or plane (2) comprising the supply zone (2a) and the printing zone (2b) is subdivided in the direction of the displacement - i.e., lengthwise - by at least two parallel slots (6, 7) and the clamping means (8) extending therethrough are free to reciprocate horizontally and vertically in the slots (6, 7).

4. An apparatus according to claim 3, characterised in that at least two clamping means (8) extend upwards through each slot (6, 7), the first such means being associated with the first edge of the panel (4) while the second such means are associated with the second edge of the panel (4), the second edge being parallel to the first edge.

5. An apparatus according to claim 3, characterised in that each clamping means (8) has a column-like support (9, 9a) having a sliding sleeve or collar or the like (12), the moving clamping element (10) of the clamping means (8) is received by a column-like support (18) having a sliding sleeve or collar or the like (17) on its underside, and a projecting arm (26) which has an inclined plane (27) is provided and also has a sliding sleeve or collar or the like (25) on its underside and the sliding sleeves (12, 17, 25) are movingly mounted on guide rails or bars or the like (13, 14) disposed parallel to one another and to the support surface or working plane (2) of the apparatus (1).

6. An apparatus according to claim 5, characterised in that an adjusting and locking screw (15) is associated with the sliding sleeve (12) of the column-like support (9).

7. An apparatus according to claim 5, characterised in that the column-like support (9) has a stop (16).

8. An apparatus according to claim 5, characterised in that the moving clamping element (10) is mounted in a casing (19) formed in its top and bottom with guide apertures (20, 21) and receives in its interior spring means (23) producing an upwards bias of the moving clamping element (10).

9. An apparatus according to claim 5, characterised in that a follower roller (24) is provided at the bottom end (l0a) of the moving clamping element (10) and is operatively engageable with the inclined plane (27) of the horizontal arm (26).

10. An apparatus according to claim 5, characterised in that support arms or ribs (28-30) project from the sliding sleeves (12, 17, 25) and receive first spring means (31) between the sleeve (12) and the column (18) and second spring means (32) between the sleeve (17) and the sleeve (25), the first spring means (31) having less spring force than the second spring means (32).

11. An apparatus according to claim 10, characterised in that a reciprocating actuator (33, 34) is disposed between the projecting arm (28) of the sleeve (12) and the projecting arm (30) of the sleeve (25).

12. An apparatus according to claim 5, characterised in that the parallel guide rails receiving the sleeves (12, 17, 25) are disposed in a framework (35) displaceably received by other parallel guide rails (37, 38) disposed parallel to the guide rails (13, 14) of the sleeves (12, 17, 25).

13. An apparatus according to claim 12, characterised in that the guide rails (37, 38) associated with the displaceable frame (35) are operatively connected to linkages or reciprocating actuators (39, 40) for raising and lowering the latter guide bars (37, 38).

14. An apparatus according to claim 12, characterised in that the movable frame (35) is operatively connected to drive means in the form of a chain (41) or a cable or a toothed rack.

## Revendications

1. Dispositif de transfert automatique de plaques de substrat pour circuits électriques imprimés d'une zone de chargement à une zone d'impression, caractérisé par la présence d'une surface de travail continue fixe unique (2) subdivisée en une zone de chargement (2a) et une zone d'impression (2b), par la présence de mécanismes de serrage (8) commandés destinés à saisir une plaque de support (4), et en ce que ces mécanismes de serrage (8) comportent des moyens (9-40) pour effectuer un mouvement de translation de va-et-vient le long d'une glissière disposée parallèlement au plan de travail (2) du dispositif, ainsi que pour effectuer un mouvement de soulèvement dirigé perpendiculairement à la surface de travail.

2. Dispositif selon la revendication 1, caractérisé par la présence, tant dans la zone de chargement (2a) que dans la zone d'impression (2b), de broches d'alignement (3) pour effectuer un ajustage préalable de la plaque de substrat (4), respectivement de broches d'alignement (5) pour effectuer un ajustage final de la plaque de substrat (4), au-dessus de perforations d'alignement formées dans la plaque de substrat (4).

3. Dispositif selon la revendication 1, caractérisé en ce que le plan (2) formant la zone de chargement (2a) et la zone d'impression (2b) est subdivisé dans la direction du mouvement de translation, donc dans la direction longitudinale, par au moins deux fentes londitudinales (6,7) disposées parallèlement l'une à l'autre, et en ce que les mécanismes de serrage (8) passant par les fentes longitudinales peuvent effectuer librement des mouvements de va-et-vient et de montée et descente dans ces fentes (6,7).

4. Dispositif selon la revendication 3, caractérisé en ce que deux mécanismes de serrage (8) au moins dépassent vers le haut par chacune des fentes (6,7), mécanismes dont le premier correspond au premier côté de la plaque de substrat (4) et le second au second côté disposé parallèlement de la plaque de substrat (4).

5. Dispositif selon la revendication 3, caractérisé en ce que chaque mécanisme de serrage (6) comporte un appui (9, 9a) en forme de colonne, qui comporte sur sa face inférieure une douille coulissante (12), en ce que l'élément de serrage mobile (10) du mécanisme de serrage (8) est également reçu par un appui (18) en forme de colonne qui comporte également une douille coulissante (17) sur sa face inférieure, par la présence, en outre, d'un bras en saillie (26), comportant un plan oblique (27) qui, comporte également, sur sa face inférieure, une douille coulissante (25), et en ce que ces douilles coulissantes (12, 17, 25) sont reçues de façon à pouvoir se déplacer par des rails de guidage (13, 14) disposés parallèlement entre eux et parallèlement au plan de travail (2) du dispositif (1).

6. Dispositif selon la revendication 5, caractérisé en ce qu'il correspond à la douille coulissante (12) de l'appui en forme de colonne (9) une vis de réglage et de blocage (15).

7. Dispositif selon la revendication 5, caractérisé en ce que l'appui en forme de colonne (9) comporte un organe de butée (16).

8. Dispositif selon la revendication 5, caractérisé en ce que l'élément de serrage mobile (10) est placé dans un boîtier (19) qui comporte sur sa face supérieure et sur sa face inférieure des ouvertures de guidage (20, 21), et loge en son intérieur un organe élastique (23) qui tend à déplacer vers le haut l'élément de serrage mobile (10).

9. Dispositif selon la revendication 5, caractérisé par la présence à l'extrémité inférieure (10a) de l'élément de serrage mobile (10) d'un galet de commande (24) pouvant entrer en interaction avec le plan oblique (27) du bras (26) disposé horizontalement.

10. Dispositif selon la revendication 5, caractérisé en ce que des bras d'appui ou des nervures (28, 29, 30) partent des douilles coulissantes (12, 17, 25) de la colonne d'appui (9), de la colonne de support (16) de l'élément de serrage (10, 10a, 10b) ainsi que du bras (26) disposé horizontalement comportant le plan oblique (27), et logent entre la douille (12) de la colonne d'appui (9) et de la colonne d'appui (18) pour l'élément de serrage mobile (10, 10a, 10b), un premier organe élastique (31) et, entre la douille coulissante (17) de la colonne d'appui (18) et la douille coulissante (25) du bras (31) disposé horizontalement, un second organe élastique (32), et en ce que l'organe élastique (31) placé entre la douille coulissante (12) de la colonne d'appui (9) et de la colonne de retenue (18) de l'élément de serrage mobile (10, 10a, 10b) une élasticité plus réduite que le ressort (32) placé entre la colonne de support (18) de l'élément de serrage mobile (10) et la douille coulissante (25) du bras (26) partant horizontalement.

11. Dispositif selon la revendication 10, caractérisé en ce qu'une unité constituée par un cylindre et un piston (33, 34) est montée entre le bras en saillie (28) de la douille coulissante (12) de la colonne d'appui (9) et le bras en saillie (30) de la douille coulissante (25) du bras (26) monté horizontalement et comportant un plan incliné.

12. Dispositif selon la revendication 5, caractérisé en ce que les rails de guidage disposés parallèlement, qui reçoivent les douilles coulissantes (12, 17, 25), sont placés dans un bâti (35) reçu lui-même de façon à pouvoir se déplacer par d'autres rails de guidage (37, 38) parallèles, disposés parallèlement aux rails de guidage (13,14) des douilles coulissantes (12, 17, 25).

13. Dispositif selon la revendication 12, caractérisé en ce que les rails de guidage (37, 38) recevant le châssis mobile (35) coopèrent avec des tringleries à leviers ou des ensembles piston-cylindre (39, 40) pour faire monter et descendre ces rails de guidage (37, 38).

14. Dispositif selon la revendication 12, caractérisé en ce que le châssis mobile (35) coopère avec un organe d'entraînement constitué par une chaîne (41), un câble ou une crémaillère.

FIG. 1

FIG. 2

FIG. 3

FIG. 4

FIG. 5

FIG. 6

FIG. 7

FIG.8